Europäisches Patentamt

European Patent Office

Office européen des brevets

(19)

(11)  EP 0 928 499 B1

(12)  EUROPÄISCHE PATENTSCHRIFT

(45) Veröffentlichungstag und Bekanntmachung des Hinweises auf die Patenterteilung:
**16.10.2002   Patentblatt 2002/42**

(21) Anmeldenummer: **98943686.0**

(22) Anmeldetag: **14.07.1998**

(51) Int Cl.$^7$: **H01L 21/66**, H01L 21/3065

(86) Internationale Anmeldenummer:
**PCT/DE98/01961**

(87) Internationale Veröffentlichungsnummer:
**WO 99/004425 (28.01.1999 Gazette 1999/04)**

(54) **VERFAHREN ZUM ERKENNEN DES ÜBERGANGS VERSCHIEDENER MATERIALIEN BEIM ÄTZEN VON HALBLEITERSTRUKTUREN**

METHOD FOR DETECTING THE TRANSITION OF DIFFERENT MATERIALS WHEN ETCHING SEMICONDUCTOR STRUCTURES

PROCEDE POUR DETECTER LA TRANSITION DE DIFFERENTS MATERIAUX PENDANT LA GRAVURE DES STRUCTURES SEMI-CONDUCTRICES

(84) Benannte Vertragsstaaten:
**CH DE FR GB LI**

(30) Priorität: **17.07.1997   DE 19730644**

(43) Veröffentlichungstag der Anmeldung:
**14.07.1999   Patentblatt 1999/28**

(73) Patentinhaber: **ROBERT BOSCH GMBH**
**70442 Stuttgart (DE)**

(72) Erfinder:
• **BECKER, Volker**
  **D-76359 Marxzell (DE)**
• **LÄRMER, Franz**
  **D-70437 Stuttgart (DE)**
• **SCHILP, Andrea**
  **D-73525 Schwäbisch Gmünd (DE)**

(56) Entgegenhaltungen:
| | |
|---|---|
| **EP-A- 0 602 855** | **EP-A- 0 821 396** |
| **WO-A-91/18283** | **DE-A- 19 524 573** |
| **DE-C- 4 241 045** | |

## Beschreibung

Die Erfindung betrifft Verfahren zum Erkennen des Übergangs verschiedener Materialien in Halbleiterstrukturen bei alternierenden Ätz- und Abdeck- beziehungsweise Abscheideschritten zur anisotropen, mittels eines Plasmas erfolgender Tiefenätzung definierter Strukturen.

## Stand der Technik

Aus der deutschen Patentschrift DE 42 41 045 C1 ist ein Plasmaätzprozess für Silicium bekannt, bei dem ein teflonartiger Schutzfilm auf die Seitenwände geätzter Strukturen aufgebracht und in einem darauffolgenden, an sich isotropen Ätzschritt mit Fluorradikalen das Silicium in die Tiefe geätzt wird. Durch Abtrag des darüberliegenden Seitenwandschutzfilms, anschließendem Transport nach unten, und Redeposition während der einzelnen Ätzschritte werden die neu erzeugten Seitenwandabschnitte stets vor dem nachfolgenden Ätzangriff geschützt, so dass eine glatte Seitenwand entsteht. Liegen in einer Halbleiterstruktur Schichten verschiedener Materialien vor, so ist die Ätzung oftmals durch eine Schicht hindurch bis zur darunter liegenden Schicht durchzuführen, das heißt, der Ätzvorgang wird bis zum Beginn einer neuen Schicht durchgeführt und dann gestoppt. Besteht zum Beispiel die obere Schicht aus Silicium und die darunter liegende Schicht aus Siliciumdioxid, so bedient man sich üblicherweise einer optischen Spektroskopie-Methode, um den Ätzprozeß nach Durchätzen der Siliciumschicht und unmittelbar nach Erreichen der Siliciumdioxidschicht zu stoppen. Die optische Methode besteht darin, daß die Stärke der Emission des Plasmas hinsichtlich eines bestimmten Stoffes mittels seiner charakteristischen Emissionswellenlänge(n) untersucht wird. Während der Ätzung von Silicium nach Art der DE 42 41 045 wird eine relativ große Menge an Fluorradikale bei der Ätzreaktion verbraucht, das heißt, die Konzentration der Fluorradikale ist relativ gering im Plasma. Gleichzeitig entstehen gasförmige Reaktionsprodukte, wie $SiF_2$, $SiF_3$, $SiF_4$, die ihrerseits eine charakteristische Emission zeigen. Wird durch die Ätzung die dielektrische Zwischenschicht, also die Siliciumdioxidschicht, erreicht, so tritt quasi ein Ätzstopp ein, da der Ätzvorgang im Siliciumdioxid wesentlich langsamer abläuft als im Silicium. Aufgrund dieses Ätzstopps nimmt der Fluorverbrauch ab; entsprechend wächst die Menge an freiem Fluor im Plasma. Dies wird durch eine entsprechende Lichtemission bei charakteristischen Wellenlängen bei der optischen Messung erkannt. Durch die Verlangsamung des Ätzprozesses beim Erreichen der Siliciumdioxid-Schicht geht ferner die $SiF_x$-Konzentration zurück, so daß deren Lichtemission bei charakteristischen Wellenlängen abnimmt, und die Emission des Sauerstoffs aus dem Siliciumdioxid bei dessen charakteristischen Wellenlängen auftritt. Auch diese Effekte sind mittels der optischen Messmethode sensierbar. Mittels der erwähnten optischen Methode kann somit der Ätzprozess beendet oder mit geänderten Parametern weitergeführt werden. Dies ist erforderlich, da ein unkontrolliertes Überätzen zu einem ungewünschten Ätzprofil, beispielsweise zu einem Anätzen der senkrechten Seitenwände, führt, so dass eine Hinterschneidung der Maske mit Strukturverlust stattfindet. Die ursprünglich erreichte Genauigkeit ist damit nicht mehr gegeben, auch kann es zu Taschenbildungen am dielektrischen Interface (zwischen Silicium und Siliciumdioxid) kommen.

Aus EP 0 602 855 A1 ist ein Verfahren zum Erkennen des Übergangs verschiedener Materialien in Halbleiterstrukturen bekannt. Dazu werden über anisotrope Ätzschritte definierte Strukturen in den Halbleiter mittels eines Plasmas eingeätzt, und eine Intensitätsmessung eines bestimmten, im Plasma enthaltenen Stoffes vorgenommen, wobei das Überschreiten eines vorgegebenen Wertes zur Erkennung des Materialüberganges dient. Weiter ist daraus bekannt, dass nach einem Transfer des zu ätzenden Halbleiterkörpers bzw. einem Wechsel des eingesetzten Ätzverfahrens beim Einschalten ein Peak entstehen kann, der bei der Erkennung des Materialüberganges unbeachtet bleiben sollte. Zu diesem Zweck werden einige bei der Intensitätsmessung aufgenommene Messpunkte ignoriert.

## Vorteile der Erfindung

Die erfindungsgemäßen Verfahren der Ansprüche 1 und 6 stellen zum Erkennen des Übergangs verschiedener Materialien in Halbleiterstrukturen bei alternierenden Ätz- und Abdeckschritten nach Art der DE 42 41 045 C1 Methoden zur Verfügung, mit denen präzise, reproduzierbare Ergebnisse erzielt werden können. (Im Zuge dieser Anmeldung werden im folgenden die Begriffe Konzentration beziehungsweise Konzentrationsmaximum verwendet, die durch die Begriffe Intensität beziehungsweise Intensitätsmaximum substituiert werden können, da die Konzentration eines im Plasma enthaltenen Stoffs und die Intensität über eine Intensitätsmessung der charakteristischen Emissionswellenlänge(n) proportional zueinander in Beziehung stehen). Hierzu ist vorgesehen, dass mittels einer Intensitätsmessung mindestens eines bestimmten, im Plasma enthaltenen Stoffs über dessen Emissionsstärke und damit seiner Konzentration der Beginn eines jeden Ätzschritts durch Erreichen eines charakteristischen Schwellenwerts ermittelt wird und dass dann mit Erreichen des Schwellenwerts eine Verzögerungszeit gestartet wird, die länger ist als der Verlauf eines ersten uncharakteristischen Konzentrationsmaximums, daß dann nach Ablauf dieser Verzögerungszeit ein zweites Konzentrationsmaximum ermittelt wird, und daß die zweiten Konzentrationsmaxima der Ätzschritte auf ein Über- oder Unterschreiten eines vorgegebenen Werts zur Erkennung des Materialübergangs überwacht werden. Anstelle der Über- oder Unterschreitung eines Schwellenwerts kann gegebenenfalls auch mittels eines Synchronisationssignals, auf dessen Generierung nicht näher eingegangen wird, das Ende beziehungsweise der Anfang des Ätzschritts ermittelt werden. Die Erfindung sieht somit vor, als wesentliche Größe ein bei jedem Ätzschritt auftretendes zweites Konzentrationsmaximum eines bestimmten, im Plasma enthaltenen Stoffes, heranzuziehen. Die Detektion dieses zweiten Maximums erfolgt dadurch, daß ein jeweils vor dem auszuwertenden Maximum liegender, uncharakteristischer Signalpeak, nämlich ein erstes Konzentrationsmaximum durch Abwarten der Verzögerungszeit unberücksichtigt bleibt. Die Verzögerungszeit wird derart gewählt, daß sie länger ist als der Verlauf des ersten Konzentrationsmaximums, so daß dieses erste Konzentrationsmaximum quasi ausgeblendet wird. Mit der Auswertung des zweiten charakteristischen Konzentrationsmaximums steht ein für das Erkennen des Übergangs verschiedener Materialien bei jedem Ätzschritt charakteristischer und damit aussagekräftiger Wert zur Verfügung. Dieser Wert wird vorzugsweise kontinuierlich, also bei jedem Ätzschritt ermittelt. Alternativ ist es jedoch auch denkbar, daß dieser Wert nicht bei jedem Ätzschritt, sondern beispielsweise bei jedem zweiten Ätzschritt ermittelt wird. Die einzelnen zweiten Konzentrationsmaxima verändern während des Ablaufs der Vielzahl der Ätzschritte ihre Größe; es besteht also eine Abhängigkeit von dem geätzten Material. Wird im Zuge der Ätzvorgänge ein Material verlassen und ein zweites Material angeätzt, so ändern sich die aussagekräftigen zweiten Konzentrationswerte, das heißt, daß ein Über- oder Unterschreiten eines vorgegebenen Werts die Aussage ermöglicht, daß das tieferliegende zweite Material erreicht wurde. Das erfindungsgemäße Verfahren gestattet überdies eine Tendenzaussage, da die Veränderung des zweiten Konzentrationsmaximums im Zuge der einzelnen Ätzschritte im wesentlichen kontinuierlich verläuft, so daß es zu einem Ansteigen beziehungsweise Abfallen der Maxima kommt, wodurch erkennbar wird, daß demnächst der Materialübergang erreicht wird. Mithin kann durch eine geeignete, kontinuierliche Auswertung eine Tendenzaussage vorgenommen werden.

Nach einer Weiterbildung der Erfindung ist vorgesehen, daß eine Spitzenwertermittlung des zweiten Konzentrationsmaximums erfolgt. Mithin wird jeweils der größte Wert erfaßt und als Auswertekriterium herangezogen. Alternativ ist es natürlich auch denkbar, daß mehrere, im Bereich der Spitze liegende Werte des zweiten Konzentrationsmaximums für die Auswertung herangezogen werden.

Dies ist beispielsweise dann der Fall, wenn das zweite Konzentrationsmaximum mittels eines Sampleand-Hold-Verfahrens ermittelt wird. Hierzu kann eine entsprechende Sample-and-Hold-Vorrichtung eingesetzt werden.

Ferner ist es vorteilhaft, wenn die mittels Fluorradikalen zu ätzende Halbleiterstruktur mindestens einen Bereich aus Silicium und mindestens einen anderen Bereich aus Siliciumdioxid aufweist, wobei das Silicium das von der Ätzseite zuerst bearbeitete Material und das Siliciumdioxid das durch den fortschreitenden Ätzprozeß zu erreichende Material ist, wobei der Anstieg der zweiten Fluorkonzentrationmaxima bis über den vorgegebenen Wert zum Erkennen des Materialübergangs von Silicium zu Siliciumdioxid führt. Die zweiten Fluorkonzentrationsmaxima bilden somit die vorstehend erwähnten zweiten Konzentrationsmaxima. Alternativ kann bei einer Ätzung von Silicium bis zu einer tieferliegenden Siliciumdioxidschicht jedoch auch vorgesehen sein, daß der Abfall eines im Plasma enthaltenen $SiF_x$-Konzentrationsmaximums bis unter den vorgegebenen Wert zum Erkennen des Materialübergangs von Silicium zu Siliciumdioxid ermittelt und ausgewertet wird.

Zeichnung

Die Erfindung wird im folgenden anhand der Figuren näher erläutert. Es zeigt

Figur 1 ein Diagramm, das die Fluorkonzentration in Abhängigkeit der Zeit bei einer Vielzahl von Ätzschritten wiedergibt,

Figur 2 ein Diagramm eines einzelnen Ätzschritts gemäß Figur 1,

Figur 3 einen Verlauf von zweiten Konzentrationsmaxima der Ätzschritte gemäß Figur 1,

Figur 4 ein Blockschaltbild, mit dessen Hilfe eine Auswertung der Meßergebnisse durchgeführt wird und

Figur 5 eine detaillierte Schaltungsausführung.

Beschreibung eines Ausführungsbeispiels

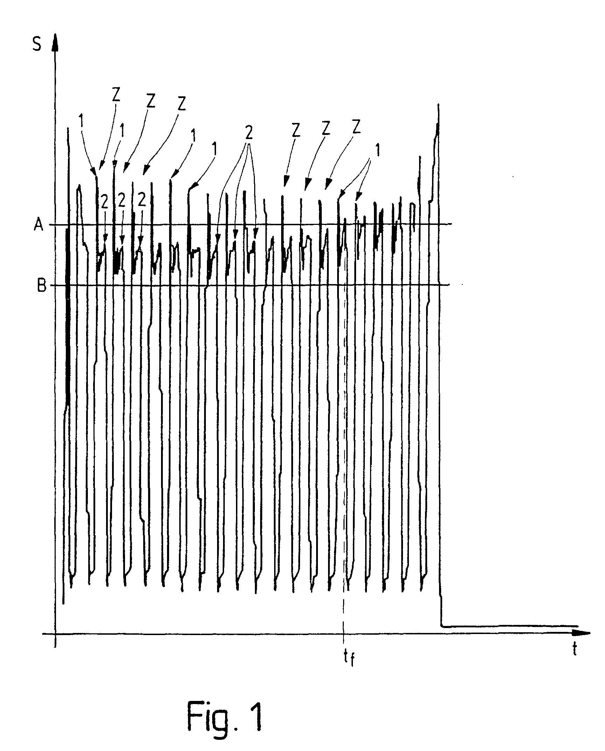

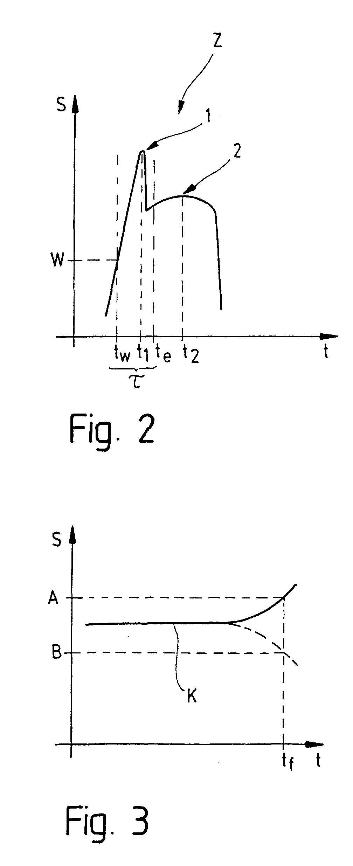

Die Figur 1 zeigt ein Diagramm, auf dessen Ordinate die Fluorkonzentration S (Signalstärke) und auf dessen Abszisse die Zeit t aufgetragen ist. Der Kurvenverlauf dieses Diagramms läßt eine Vielzahl von Ätzschritten Z erkennen, das heißt, die Fluorkonzentration wächst bei jedem Ätzschritt Z bis auf einen Maximalwert und fällt dann -wenn der Ätzschritt beendet wird- auf einen Minimalwert ab. Bei der durchgeführten Ätzung handelt es sich um eine mittels Plasma erfolgende Tiefenätzung einer Halbleiterstruktur zum Beispiel für einen Sensor, wobei -von der Ätzseite her gesehen- das Material Silicium (Si) bis zu einer tieferliegenden Schicht aus Siliciumdioxid ($SiO_2$) geätzt wird. Dies erfolgt durch eine Vielzahl der aus Figur 1 ersichtlichen Ätzschritte, wobei bei jedem Ätzschritt die Seitenwände der geätzten Struktur mittels eines teflonartigen Schutzfilms geschützt werden. Das Plasma weist Fluorradikale auf, wobei wegen des diskontinuierlichen Prozesses die Konzentration an freiem Fluor stark periodisch schwankt, wie dies aus dem Verlauf der Kurve in Figur 1 ersichtlich ist. Zu Beginn einer jeden Ätzung Z erreicht die Fluorkonzentration S ein erstes Konzentrationsmaximum 1, dem -nach Ablauf einer bestimmten Zeitspanne- ein zweites Konzentrationsmaximum 2 folgt. Dies ist im Detail deutlich der Figur 2 zu entnehmen, die -in vergrößerter Darstellung- einen Ätzschritt Z hinsichtlich des Zeitverlaufs der Fluorkonzentration S zeigt. Deutlich ist das erste Konzentrationsmaximum 1 zu erkennen, das zum Zeitpunkt $t_1$ vorliegt. Zu dem späteren Zeitpunkt $t_2$ stellt sich das zweite Konzentrationsmaximum 2 ein. Ein Vergleich des ersten Konzentrationsmaximums 1 sowie des zweiten Konzentrationsmaximums 2 der Ätzschritte Z in Figur 1 zeigt, daß es sich bei dem ersten Konzentrationsmaximum 1 um einen hinsichtlich des fortschreitenden Ätzprozesses uncharakteristischen Wert, also ein Prozeßartefakt handelt, das heißt, die Größe stellt insofern für das Erreichen der Siliciumdioxid-Schicht keine charakteristische Größe dar. Dies ist anders bei dem zweiten Konzentrationsmaximum 2. Eine Betrachtung der einzelnen Ätzschritte mit fortlaufender Zeit (Figur 1) läßt erkennen, daß mit Fortschreiten der Ätzperioden das zweite Konzentrationsmaximum 2 ansteigt. Dieser Anstieg resultiert aus der Zunahme an freiem Fluor im Plasma, da beim Erreichen der Siliciumdioxidschicht der Fluorverbrauch für die Ätzung abnimmt und daher die Konzentration des Fluors im Plasma zunimmt. Die Ermittlung des freien Fluors im Plasma erfolgt vorzugsweise mittels eines optischen Verfahrens, beispielsweise wird die Lichtemission bei für Fluor charakteristischen Wellenlängen gemessen. Um bei der Auswertung die uncharakteristischen ersten Konzentrationsmaxima unberücksichtigt zu lassen, ist -gemäß Figur 2- eine Verzögerungzeit τ vorgesehen, die mit einem Schwellenwert W der Fluorkonzentration zum Zeitpunkt $t_w$ beginnt und zum Zeitpunkt $t_e$ endet.

Aus der Figur 2 ist ersichtlich, daß im Zeitbereich der Verzögerungszeit τ der erste Peak der Fluorkonzentration liegt. Die Größe des Schwellenwerts W wird in Abhängigkeit vorliegender Prozeßgrößen festgelegt. Der Schwellenwert W kennzeichnet den jeweiligen Start der einzelnen Ätzschritte Z. Er bildet somit einen "Trigger" für den Start der Verzögerungszeit τ. Wichtig ist dabei, daß der Schwellenwert W beziehungsweise die Verzögerungszeit τ derart gewählt sind, daß stets sicher das erste Konzentrationsmaximum 1 innerhalb der Verzögerungszeit τ liegt und demzufolge ausgeblendet werden kann, das heißt nicht für die Auswertung herangezogen wird.

Um zu erkennen, daß die gewünschte Ätztiefe erreicht wurde, also daß die Siliciumdioxidschicht freigelegt ist, wird ein aus der Figur 1 ersichtlicher vorgegebener Wert A herangezogen, dessen Größe aufgrund der Prozeßparameter bestimmt ist. Wird dieser Wert A im Zuge des Verlaufs der Ätzschritte vom jeweiligen zweiten Konzentrationsmaximum 2 überschritten, so läßt dies die Aussage zu, daß die Ätzung die gewünschte Tiefe erreicht hat, das heißt, die Siliciumdioxidschicht ist freigelegt. In der Figur 1 ist dies zum Zeitpunkt $t_f$ gegeben.

Die Figur 3 erläutert diesen Vorgang. Aufgetragen ist auf der Ordinate des Diagramms der Figur 3 die Fluorkonzentration S und auf der Abszisse die Zeit t. Die Kurve K stellt den Verlauf der zweiten Konzentrationsmaxima 2 über den gesamten Ätzprozeß, also über die Vielzahl der Ätzschritte Z dar. Es ist erkennbar, daß sie mit fortschreitender Zeit ansteigt (durchgezogene Linie), das heißt, die Größe der zweiten Konzentrationsmaxima nimmt zum Ende des Ätzprozesses hin zu, wobei sie im Zeitpunkt $t_f$ den vorgegebenen Wert A schneidet. Dies bedeutet, daß durch den Ätzvorgang die Siliciumdioxidschicht freigelegt wurde. Mithin läßt das vorstehend erwähnte Vorgehen ein Erkennen des Übergangs verschiedener Materialien zu.

In den Figuren 1 und 3 ist -nach einem anderen, hier nicht näher erläuterten Ausführungsbeispielferner ein vorgegebener Wert B sowie ein nach unten erfolgender Abfall der Kurve K (gestrichelte Linie) erkennbar. Wird -entsprechend dem vorstehend erläuterten Prozeß- nicht die Fluorkonzentration, sondern die Konzentration anderer gasförmiger Reaktionsprodukte, wie beispielsweise $SiF_2$, $SiF_3$ oder $SiF_4$ (also $SiF_x$) beim Ätzprozeß ermittelt, so nimmt diese Konzentration gemäß der gestrichelten Linie der Figur 3 am Ende des Ätzprozesses ab. Bei dem jeweiligen Konzentrationswert handelt es sich ebenfalls um zweite Konzentrationswerte, nämlich zweite Konzentrationsmaxima der genannten $SiF_X$-Konzentration. Unterschreitet dieses Konzentrationsmaximum den vorgegebenen Wert B, so ist dies ein Zeichen dafür, daß die Ätzung beendet werden kann, da im Zuge der einzelnen Ätzschritte die Siliciumdioxidschicht freigelegt worden ist.

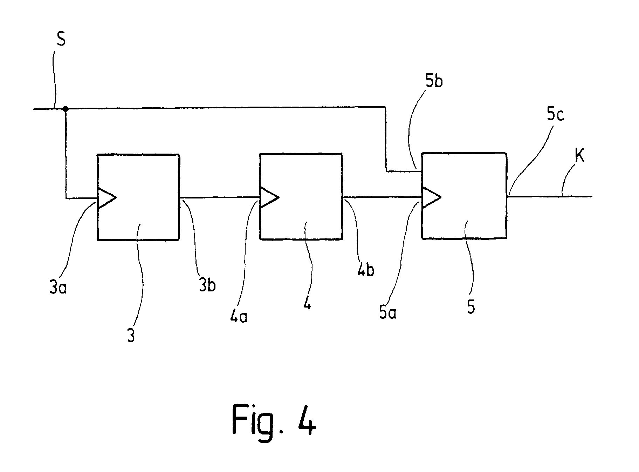

Die Figur 4 zeigt eine Realisierung in Form eines Blockschaltbilds zur Ermittlung der zweiten Konzentrationsmaxima 2. Im Blockschaltbild der Figur 4 ist ein Schwellenwert-Trigger-Element 3, ein Verzögerungselement 4 und ein deaktivierbarer Spitzenwert-Detektor 5 dargestellt, die elektrisch miteinander verbunden sind. Als Eingangsgröße des Schwellenwert-Trigger-Elements 3 wird die Fluorkonzentration S des Plasmas verwendet, die direkt an den Eingang 3a angeschlossen ist. Das Ausgangssignal 3b des Schwellenwert-Trigger-Elements 3 wird dem Verzögerungselement 4 als Eingangssignal 4a zur Verfügung gestellt. Das Ausgangssignal 4b des Verzögerungselements 4 wird dem Spitzenwert-Detektor 5 als ein erstes Eingangssignal 5a zugeleitet und schaltet diesen aktiv oder deaktiv. Der Spitzenwert-Detektor 5 erhält ein weiteres, zweites Eingangssignal 5b, das die Fluorkonzentration S repräsentiert. Am Ausgang des Spitzenwert-Detektors 5 stehen die zweiten Konzentrationsmaxima K gemäß Figur 3 zur Verfügung.

Es ergibt sich folgende Funktion: Das Schwellenwert-Trigger-Element vergleicht das an seinem Eingang 3a anliegende Signal der Fluorkonzentration S mit dem vorstehend beschriebenen Schwellenwert W. Der Schwellenwert W ist hinsichtlich der Prozeßparameter in seiner Größe vorgebbar. Erreicht die Fluorkonzentration S einen Wert, der größer ist als der vorgegebene Schwellenwert W, so wird vom Schwellenwert-Trigger-Element 3 ein Ausgangssignal 3b erzeugt, das als Eingangssignal 4a dem Verzögerungselement 4 zugeführt wird. Hierdurch startet des Verzögerungselement 4 die Verzögerungszeit τ, deren Größe ebenfalls in Abhängigkeit der Prozeßparameter bei der vor Inbetriebnahme erfolgten Kalibrierung vorgegeben worden ist. Der Start der Verzögerungszeit τ kann auch durch ein Synchronisationssignal der Ätzmaschine, das Beginn und Ende jedes Ätzschritts anzeigt, angetriggert werden, wobei beim Start der Verzögerungszeit τ der Beginn jedes Ätzschritts relevant ist. Solange die Verzögerungszeit τ abläuft, wird der Spitzenwert-Detektor 5 deaktiviert. Ist die Verzögerungszeit τ abgelaufen, so wird mittels des Ausgangssignals 4b des Verzögerungselements 4 der Spitzenwert-Detektor 5 an seinem Eingang 5b aktiviert. Ist der Spitzenwert-Detektor 5 aktiviert, so verwendet er das an seinem Eingang anliegende Eingangssignal 5b, nämlich die Fluorkonzentration S, um an seinen Ausgang 5c den Spitzenwert der Fluorkonzentration S zu erzeugen. Mittels nachfolgender, jedoch nicht dargestellter Komponenten erfolgt schließlich noch ein Vergleich der zweiten Konzentrationsmaxima 2 mit dem vorgegebenen Wert A beziehungsweise B, um eine Aussage über das Erkennen des Übergangs verschiedener Materialien in Halbleiterstrukturen während des Ätzprozesses treffen zu können.

Der in Figur 4 dargestellte Spitzenwert-Detektor 5 kann, in einer hier nicht näher erläuterten Realisierung, durch ein Sample-and-Hold-Element ersetzt werden, wobei dieses Sample-and-Hold-Element durch mehrfache Abtastung der Fluorkonzentration S und Abspeicherung dieser Fluorkonzentrationswerte mittels eines Komparators den auf diese Weise ermittelten angenäherten zweiten Konzentrationsmaximalwert an seinem Ausgang bereitstellt. Das Sample-and-Hold-Element wird, ebenso wie beim Spitzenwert-Detektor 5, durch das vom Verzögerungselement 4 kommende Eingangssignal 5a aktiviert beziehungsweise deaktiviert.

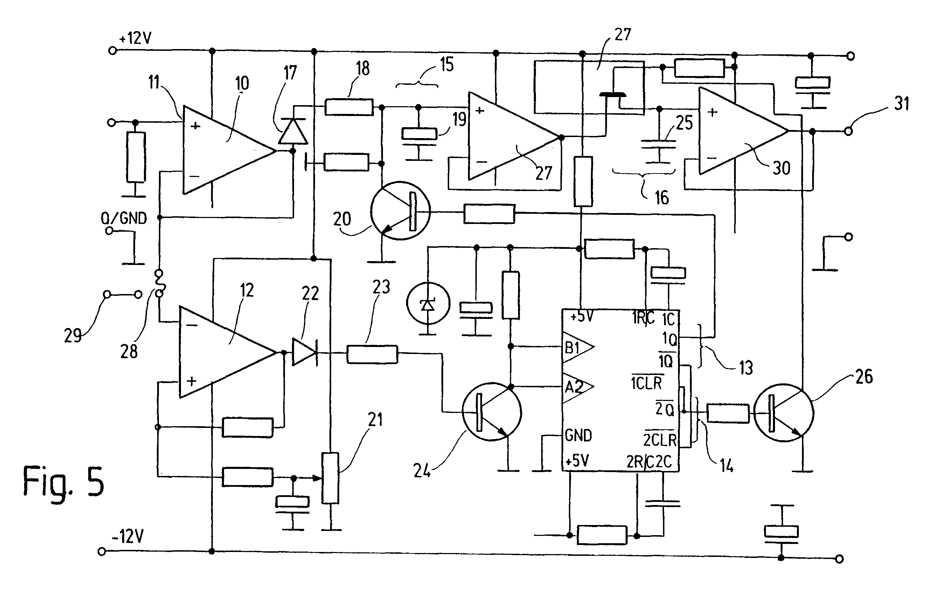

Die Figur 5 zeigt eine detaillierte Schaltungsausführung zur Realisierung der Erfindung in Form eines Schaltplans. Die Schaltung besteht aus folgenden wesentlichen Komponenten:

Es ist ein Impedanzwandler 10 mit einem Verstärkungsfaktor eins vorgesehen, an dessen Eingang 11 das bei der Konzentrationsmessung ermittelte Signal als Ausgangssignal eines optischen Emissionsspektrometers anliegt. Ferner ist ein Komparator 12 mit Hysterese vorgesehen. Als wesentliche Komponenten sind überdies zwei Zeitgeber (Monoflops) 13 und 14 zu nennen, wobei der Zeitgeber 13 zur Realisierung der Verzögerungszeit τ einer Sampling-Stufe 15 genutzt wird und der Zeitgeber 14 zur Übernahme der Information aus der Sampling-Stufe 15 an einer Hold-Stufe 16 vorgesehen ist.

Es ergibt sich folgende Funktion: Das Ausgangssignal des optischen Emissionsspektrometers, das am Eingang 11 des Impedanzwandlers 10 anliegt, wird mit dem Verstärkungsfaktor eins zur Entkopplung von der übrigen Schaltungselektronik über eine Diode 17 und einen Vorwiderstand 18 auf einen Speicherkondensator 19 und somit auf die Sampling-Stufe 15 geführt. Durch die Anordnung aus Diode 17 und Speicherkondensator 19 wird jeweils der Maximalwert der pro Ätzschritt erreichten Ausgangsspannung des optischen Emissionsspektrometers gespeichert. Zum Speicherkondensator 19 ist ein Entladetransistor 20 parallel geschaltet, wobei letzterer den Kondensator 19 während der Verzögerungszeit τ kurzschließt, wodurch das Sampling inaktiv geschaltet ist. Während der Verzögerungszeit τ wird also der Speicherkondensator 19 auf Null gesetzt und kann daher nicht geladen werden. Das Steuern der Verzögerungszeit τ übernimmt der Komparator 12 mit Hysterese: Überschreitet die Ausgangsspannung des Emissionsspektrometers den mit einem "Trigger-Level"-Potentiometer 21 voreingestellten Schwellenwert W, so wird der Zeitgeber 13 über eine Diode 22, einen Widerstand 23 und ein Transistor 24 mit der ansteigenden Flanke des Spannungssignals am Kollektor vom Transistor 24 für die Verzögerungszeit τ gestartet. Der Ausgang 1Q des Zeitgebers 13 geht dadurch auf High-Potential und schließt über den Transistor 20 den Speicherkondensator 19 der Sampling-Stufe 15 während des Ablaufens der Verzögerungszeit τ kurz. Nach Ablauf der Verzögerungszeit τ wird der Speicherkondensator 19 freigegeben, so daß er den Maximalwert 2 der beim aktuellen Ätzzyklus erreichten Ausgangsspannung des optischen Emissionsspektrometers speichern kann. Solange der Ätzzyklus läuft, das heißt die gemessene Ausgangsspannung des optischen Emissionsspektrometers über dem Schwellenwert W liegt, ist auch der Kollektor von dem Transistor 24 auf High-Potential. Am Ende des Ätzzyklus fällt die Ausgangsspannung des optischen Emissionsspektrometers und damit die Eingangsspannung am Eingang 11 unter den Schwellenwert W und der Kollektor des Transistors 24 fällt auf Low-Potential ab. Mit der fallenden Flanke der Kollektorspannung von Transistor 24 wird der Zeitgeber 14 gesetzt, um die auf dem Speicherkondensator 19 gespeicherte, während des vorangehenden Ätzzyklus erreichte Maximalspannung auf einen Speicherkondensator 25 der Hold-Stufe 16 zu übertragen. Dabei generiert der Zeitgeber 14 einen kurzen Ausgangsimpuls an seinem Ausgang $\overline{2Q}$ der über einen Transistor 26 und ein Schalter-IC 27 dem Speicherkondensator 25 der Hold-Stufe 16 kurzzeitig mit dem Ausgang eines Pfufferverstärkers 27 verbindet. Dabei wird der von dem Speicherkondensator 19 der Sampling-Stufe 15 gespeicherte Maximalwert der im vorangegangenen Ätzzyklus erreichten Spannung auf den Speicherkondensator 25 der Hold-Stufe 16 übertragen und dort gehalten. Die beiden Zeitgeber 13 und 14 sind gegeneinander verriegelt, das heißt der Ausgang $\overline{1Q}$ wirkt auf den Clear-Eingang $\overline{2CLR}$ und $\overline{2Q}$ wirkt auf den Clear-Eingang $\overline{1CLR}$, so daß nur jeweils ein Zeitgeber zur gleichen Zeit gesetzt sein kann. Damit wird vermieden, daß während des übertragens der Sample-Information auf die Hold-Stufe 16 bereits ein Löschen der Sample-Information erfolgen kann beziehungsweise daß während des Löschens der Sample-Information ein Übertragen auf die Hold-Stufe 16 erfolgen kann.

Die Hold-Stufe 16 speichert also jeweils den Maximalwert 2 der im vorhergehenden Ätzschritt erreichten Signalintensität und wird nach jedem Ätzschritt mit dem neuen Maximalwert 2 aktualisiert. Der Eingang des Komparators 12 mit Hysterese kann wahlweise mit dem Ausgang des Entkopplungsverstärkers/Impedanzwandlers 10 verbunden werden und damit -wie beschrieben- die Ausgangsspannung des Emissionsspektrometers zum Erkennen von Ätz- oder Depositionsschritten, das heißt Beginn und Ende jedes Ätzschritts, herangezogen werden, oder man verbindet den Eingang vom Komparator 12 durch Setzen eines "Jumpers" 28 mit dem Synchronisationssignal der Ätzanlage über einen externen Triggereingang 29 der Schaltung. Die Ätzanlage teilt dem Komparator 12 dann per Spannungssignal mit, wann geätzt wird oder wann die Deposition durchgeführt wird. Ein Operationsverstärker 30 dient dazu, den Spannungswert der Hold-Stufe 16 auf seinen Schaltungsausgang 31 zu übertragen, wobei der Schaltungsausgang 31 so dimensioniert ist, daß eine gewisse Belastung erfolgen kann. Der Pufferverstärker 27 dient dazu, den Umladevorgang vom Kondensator 19 auf den Kondensator 25 zu ermöglichen, ohne daß es aufgrund einer Belastung zu einem Spannungseinbruch kommt.

**Patentansprüche**

1. Verfahren zur anisotropen Tiefenätzung von Halbleiterstrukturen mittels eines Plasmas, wobei alternierende Ätzschritte und Abdeck- oder Abscheideschritte durchgeführt werden, in dem mittels einer Intensitätsmessung mindestens eines bestimmten, in dem Plasma enthaltenen Stoffes dessen Konzentration als Funktion der Zeit ermittelt wird, wobei ein Beginn eines jeden Ätzschrittes durch Erreichen eines festzulegenden Schwellenwertes (W) für die gemessene Intensität ermittelt wird, mit dem Erreichen des Schwellenwertes (W) eine Verzögerungszeit ($\tau$) gestartet wird, die länger ist als eine vorgegebene Verlaufsdauer eines auftretenden uncharakteristischen Intensitätsmaximums (1), wodurch es ermöglicht wird, dieses bei der Intensitätsmessung unberücksichtigt zu lassen, und nach Ablauf der Verzögerungszeit ($\tau$) mittels der Intensitätsmessung ein charakteristisches Intensitätsmaximum (2) ermittelt wird, und wobei das ermittelte charakteristische Intensitätsmaximum (2) auf ein Überschreiten oder Unterschreiten eines vorgegebenen Wertes (A, B) zur Erkennung eines Materialübergangs in der Halbleiterstruktur überwacht wird.

2. Verfahren nach Anspruch 1, **dadurch gekennzeichnet, dass** das charakteristische Intensitätsmaximum (2) über eine Spitzenwertermittlung oder nach einem Sample-and-Hold-Verfahren ermittelt wird.

3. Verfahren nach Anspruch 1 oder 2, **dadurch gekennzeichnet, dass** das charakteristische Intensitätsmaximum (2) bei jedem Ätzschritt ermittelt wird.

4. Verfahren nach einem der vorangehenden Ansprüche, **dadurch gekennzeichnet, dass** die Ätzung mittels Fluorradikalen erfolgt, wobei die zu ätzende Halbleiterstruktur mindestens einen Bereich aus Silizium (Si) und mindestens einen anderen Bereich aus Siliziumdioxid ($SiO_2$) aufweist und das Silizium (Si) das von der Ätzseite zuerst bearbeitete Material und das Siliziumdioxid ($SiO_2$) das durch den fortschreitenden Ätzprozess zu erreichende Material ist, und wobei als charakteristisches Intensitätsmaximum (2) ein Fluorkonzentrationsmaximum (2), ein Sauerstoffkonzentrationsmaximum oder ein $SiF_x$-Konzentrationsmaximum ermittelt wird.

5. Verfahren nach Anspruch 4, **dadurch gekennzeichnet, dass** ein Ansteigen des Fluorkonzentrationsmaximums (2) oder des Sauerstoffkonzentrationsmaximums bis über den vorgegebenen Wert (A) zu einem Erkennen eines erreichten Materialübergangs von Silizium (Si) zu Siliziumdioxid ($SiO_2$) führt, oder **dass** ein Abfallen des $SiF_x$konzentrationsmaximums bis unter den vorgegebenen Wert (B) zu einem Erkennen eines erreichten Materialübergangs von Silizium (Si) zu Siliziumdioxid ($SiO_2$) führt.

6. Verfahren zur anisotropen Tiefenätzung von Halbleiterstrukturen mittels eines Plasmas, wobei alternierende Ätzschritte und Abdeck- oder Abscheideschritte durchgeführt werden, in dem mittels einer Intensitätsmessung mindestens eines bestimmten, in dem Plasma enthaltenen Stoffes dessen Konzentration als Funktion der Zeit ermittelt wird, wobei ein Beginn eines jeden Ätzschrittes durch ein von der Ätzmaschine ausgehendes Synchronisationssignal erkannt wird, mit dem Synchronisationssignal eine Verzögerungszeit ($\tau$) gestartet wird, die länger ist als eine vorgegebene Verlaufsdauer eines auftretenden uncharakteristischen Intensitätsmaximums (1), wodurch es ermöglicht wird, dieses bei der Intensitätsmessung unberücksichtigt zu lassen, und nach Ablauf der Verzögerungszeit ($\tau$) mittels der Intensitätsmessung ein charakteristisches Intensitätsmaximum (2) ermittelt wird, und wobei das ermittelte charakteristische Intensitätsmaximum (2) auf ein Überschreiten oder Unterschreiten eines vorgegebenen Wertes (A, B) zur Erkennung eines Materialübergangs in der Halbleiterstruktur überwacht wird.

7. Verfahren nach Anspruch 6, **dadurch gekennzeichnet, dass** ein Ende eines jeden Ätzschrittes durch ein von der Ätzmaschine ausgehendes Synchronisationssignal erkannt wird.

8. Verfahren nach Anspruch 6, **dadurch gekennzeichnet, dass** das charakteristische Intensitätsmaximum (2) über eine Spitzenwertermittlung oder nach einem Sample-and-Hold-Verfahren ermittelt wird.

9. Verfahren nach einem der Ansprüche 6 bis 8, **dadurch gekennzeichnet, dass** die Ätzung mittels Fluorradikalen erfolgt, wobei die zu ätzende Halbleiterstruktur mindestens einen Bereich aus Silizium (Si) und mindestens einen anderen Bereich aus Siliziumdioxid ($SiO_2$) aufweist und das Silizium (Si) das von der Ätzseite zuerst bearbeitete Material und das Siliziumdioxid ($SiO_2$) das durch den fortschreitenden Ätzprozess zu erreichende Material ist, und wobei als charakteristisches Intensitätsmaximum (2) ein Fluorkonzentrationsmaximum (2), ein Sauerstoffkonzentrationsmaximum oder ein $SiF_x$-Konzentrationsmaximum ermittelt wird.

10. Verfahren nach Anspruch 9, **dadurch gekennzeichnet, dass** ein Ansteigen des Fluorkonzentrationsmaximums (2) oder des Sauerstoffkonzentrationsmaximums bis über den vorgegebenen Wert (A) zu einem Erkennen eines erreichten Materialübergangs von Silizium (Si) zu Siliziumdioxid ($SiO_2$) führt, oder **dass** ein Abfallen des $SiF_x$konzentrationsmaximums bis unter den vorgegebenen Wert (B) zu einem Erkennen eines erreichten Materialübergangs von Silizium (Si) zu Siliziumdioxid ($SiO_2$) führt.

**Claims**

1. Method for the anisotropic depth etching of semiconductor structures by means of a plasma, alternate etching steps and covering or deposition steps being carried out, in which, by means of an intensity measurement of at least one specific substance contained in the plasma, the concentration of the said substance is determined as a function of time, a beginning of each etching step being determined by the reaching of a threshold value (W), which is to be defined, for the measured intensity, a delay time ($\tau$) being started when the threshold value (W) is reached, which delay time is longer than a predetermined profile duration of an uncharacteristic intensity maximum (1) that occurs, as a result of which it becomes possible to leave the said intensity maximum out of consideration during the intensity measurement, and, after the delay time ($\tau$) has elapsed, a characteristic intensity maximum (2) being determined by means of the intensity measurement, and the characteristic intensity maximum (2) determined being monitored with regard to a predetermined value (A, B) being exceeded or undershot, for the purpose of identifying a material transition in the semiconductor structure.

2. Method according to Claim 1, **characterized in that** the characteristic intensity maximum (2) is determined by means of a peak value determination or according to a sample-and-hold method.

3. Method according to Claim 1 or 2, **characterized in that** the characteristic intensity maximum (2) is determined during each etching step.

4. Method according to one of the preceding claims, **characterized in that** the etching is effected by means of fluorine radicals, the semiconductor structure to be etched having at least one region made of silicon (Si) and at least one other region made of silicon dioxide ($SiO_2$) and the silicon (Si) being the material which is processed first from the etching side, and the silicon dioxide ($SiO_2$) being the material which is to be reached by the advancing etching process, and a fluorine concentration maximum (2), an oxygen concentration maximum or an $SiF_x$ concentration maximum being determined as the characteristic intensity maximum (2).

5. Method according to Claim 4, **characterized in that** a rise in the fluorine concentration maximum (2) or in the oxygen concentration maximum beyond the predetermined value (A) leads to identification of a material transition having been reached from silicon (Si) to silicon dioxide ($SiO_2$), or **in that** a fall in the $SiF_x$ concentration maximum to below the predetermined value (B) leads to identification of a material transition having been reached from silicon (Si) to silicon dioxide ($SiO_2$).

6. Method for the anisotropic depth etching of semiconductor structures by means of a plasma, alternate etching steps and covering or deposition steps being carried out, in which, by means of an intensity measurement of at least one specific substance contained in the plasma, the concentration of the said substance is determined as a function of time, a beginning of each etching step being identified by a synchronization signal emerging from the etching machine, which synchronization signal is used to start a delay time (τ) which is longer than a predetermined profile duration of an uncharacteristic intensity maximum (1) that occurs, as a result of which it becomes possible to leave the said intensity maximum out of consideration during the intensity measurement, and, after the delay time (τ) has elapsed, a characteristic intensity maximum (2) being determined by means of the intensity measurement, and the characteristic intensity maximum (2) determined being monitored with regard to a predetermined value (A, B) being exceeded or undershot, for the purpose of identifying a material transition in the semiconductor structure.

7. Method according to Claim 6, **characterized in that** an end of each etching step is identified by a synchronization signal emerging from the etching machine.

8. Method according to Claim 6, **characterized in that** the characteristic intensity maximum (2) is determined by means of a peak value determination or according to a sample-and-hold method.

9. Method according to one of Claims 6 to 8, **characterized in that** the etching is effected by means of fluorine radicals, the semiconductor structure to be etched having at least one region made of silicon (Si) and at least one other region made of silicon dioxide ($SiO_2$) and the silicon (Si) being the material which is processed first from the etching side, and the silicon dioxide ($SiO_2$) being the material which is to be reached by the advancing etching process, and a fluorine concentration maximum (2), an oxygen concentration maximum or an $SiF_x$ concentration maximum being determined as the characteristic intensity maximum (2).

10. Method according to Claim 9, **characterized in that** a rise in the fluorine concentration maximum (2) or in the oxygen concentration maximum beyond the predetermined value (A) leads to identification of a material transition having been reached from silicon (Si) to silicon dioxide ($SiO_2$), or **in that** a fall in the $SiF_x$ concentration maximum to below the predetermined value (B) leads to identification of a material transition having been reached from silicon (Si) to silicon dioxide ($SiO_2$).

**Revendications**

1. Procédé de gravure profonde anisotrope de structures semiconductrices à l'aide d'un plasma, selon lequel

   - on effectue des étapes de gravure alternées et des étapes de recouvrement et de dépôt au cours desquelles, par une mesure d'intensité d'au moins un corps déterminé contenu dans le plasma, on détermine sa concentration en fonction du temps,

   - on détermine le début de chaque étape de gravure lorsqu'on atteint un seuil à fixer (W) pour l'intensité mesurée, on démarre une durée de temporisation (τ) lorsqu'on atteint la valeur de seuil (W), cette durée étant plus longue qu'une durée de parcours prédéterminée d'un maximum d'intensité (1) non caractéristique, qui se produit, ce qui permet de ne pas en tenir compte lors de la mesure de l'intensité,

   - après la durée de temporisation (τ), à l'aide de la mesure d'intensité, on détermine un maximum d'intensité caractéristique (2), et

   - on surveille si le maximum d'intensité caractéristique (2) déterminé dépasse vers le haut et vers le bas une valeur prédéterminée (A, B) pour détecter une transition de matière dans la structure semiconductrice.

2. Procédé selon la revendication 1,
   **caractérisé en ce qu'**
   on détermine le maximum d'intensité caractéristique (2) en déterminant une valeur de pointe ou selon un procédé d'échantillonnage et de maintien.

3. Procédé selon la revendication 1 ou 2,
   **caractérisé en ce qu'**
   on détermine le maximum d'intensité caractéristique (2) à chaque étape de gravure.

4. Procédé selon l'une des revendications précédentes
   **caractérisé en ce qu'**
   on effectue la gravure en l'aide de radicaux de fluor, la structure semiconductrice à graver présentant au moins une zone en silicium (Si) et au moins une autre zone en dioxyde de silicium ($SiO_2$),
   le silicium (Si) étant la matière à travailler d'abord du côté de la gravure et le dioxyde de silicium ($SiO_2$) est la matière que l'on atteint par la progression de la gravure, et
   le maximum d'intensité caractéristique (2) est un maximum de concentration de fluor (2), un maximum de concentration d'oxygène ou un maximum de concentration de $SiF_x$.

5. Procédé selon la revendication 4,
   **caractérisé en ce qu'**
   une augmentation du maximum de la concentration de fluor (2) ou du maximum de la concentration d'oxygène jusqu'à une valeur prédéterminée (A) conduit à la reconnaissance d'une transition de matière atteinte, entre le silicium (Si) et le dioxyde de silicium ($SiO_2$), ou
   une diminution du maximum de concentration de Si-

$F_x$ jusqu'en dessous de la valeur prédéterminée (B) conduit à la reconnaissance d'une transition de matière atteinte entre le silicium (Si) et le dioxyde de silicium ($SiO_2$).

6. Procédé de gravure profonde anisotrope de structure semiconductrice avec un plasma, selon lequel on effectue une alternance d'étapes de gravures et d'étape de recouvrement ou de dépôt, selon lequel

   - à l'aide d'une mesure d'intensité d'au moins une matière déterminée, contenue dans le plasma, on détermine sa concentration en fonction du temps,
   - on reconnaît un début d'une étape de gravure par un signal de synchronisation émis par la machine de gravure,
   - on démarre avec le signal de synchronisation, une durée de temporisation ($\tau$), plus longue qu'une durée prédéterminée d'un maximum d'intensité non caractéristique (1), qui se produit, ce qui permet de ne pas tenir compte de cette mesure d'intensité et
   - à la fin de la durée de temporisation ($\tau$), à l'aide de la mesure d'intensité, on détermine un maximum d'intensité caractéristique (2) et
   - on surveille si le maximum d'intensité caractéristique (2), obtenu, dépasse vers le haut ou vers le bas une valeur prédéterminée (A, B) pour reconnaître une transition de matière dans la structure semiconductrice.

7. Procédé selon la revendication 6,
   **caractérisé en ce qu'**
   on reconnaît une fin de chaque étape de gravure par un signal de synchronisation émis par la machine de gravure.

8. Procédé selon la revendication 6,
   **caractérisé en ce qu'**
   on détermine le maximum caractéristique de l'intensité (2) en déterminant une valeur maximale ou selon un procédé d'échantillonnage et de maintien.

9. Procédé selon l'une des revendications 6 à 8,
   **caractérisé en ce qu'**
   on effectue la gravure par des radicaux fluorés et la structure semiconductrice à graver comporte au moins une zone en silicium (Si) et au moins une autre zone de dioxyde de silicium ($SiO_2$),
   le silicium (Si) étant la matière à travailler en premier lieu du côté de la gravure et le dioxyde de silicium ($SiO_2$) étant la matière que l'on atteint à la suite de la progression de la gravure, et
   comme maximum d'intensité caractéristique (2), on détermine un maximum de concentration de fluor, un maximum de concentration d'oxygène ou un maximum de concentration de $SiF_x$.

10. Procédé selon la revendication 9,
    **caractérisé en ce qu'**
    une augmentation du maximum de concentration de fluor (2) ou du maximum de concentration d'oxygène jusqu'à une valeur prédéterminée (A) conduit à la reconnaissance de ce que l'on atteint une transition de matière entre le silicium (Si) et le dioxyde de silicium ($SiO_2$), ou
    une diminution du maximum de la concentration de $SiF_x$ jusqu'en dessous de la valeur prédéterminée (B) conduit à la reconnaissance de ce que l'on a atteint une transition de matière du silicium (Si) ou dioxyde de silicium ($SiO_2$).

Fig. 1

Fig. 2

Fig. 3

Fig. 4

Fig. 5

EP 0 928 499 B1

13